# EUROPEAN PATENT APPLICATION

(11) **EP 2 658 125 A2**
(43) Date of publication of application: **30.10.2013**
(21) Application number: 13162233.4
(22) Date of filing: 03.04.2013
(51) Int. Cl.: H03K 5/1254

(54) **Switch circuit and electronic device**

(30) Priority: 23.04.2012 CN 201210119734
(71) Applicant: Hong Fu Jin Precision Industry (ShenZhen) Co., Ltd., Shenzhen City, Guangdong 518109 (CN); Hon Hai Precision Industry Co., Ltd., New Taipei City (TW)
(72) Inventor: Xu, Zhen-Ji, Shenzhen City, 518109 Guangdong Province (CN); Shi, Yong-Song, Shenzhen City, 518109 Guangdong Province (CN)
(74) Representative: Gray, John James

(57) **Abstract**

A switch circuit (100) controls a power supply (200). The switch circuit (100) includes a control unit (40), and a key switch (20) establishing an electrical connection between the power supply (200) and the control unit (40) in response to an operation by a user. When the key switch (20) establishes the electrical connection, the control unit (40) receives a supply voltage from the power supply (200) and is charged-up by the supply voltage to generate a first control signal, the first control signal enables the power supply (200) to power a load (300).

## Description

### Description of Related Art

An electronic device includes a switch control circuit, a power supply, and a load. The switch control circuit includes a key switch and a control unit. When the electronic device is powered on, the power supply powers the key switch and the load. When the electronic device is powered off, the power supply still powers the key switch and stops powering the load. The key switch generates a first command or a second command in response to an operation by the user. The control unit enables the power supply to power the load in response to the first command or enables the power supply to stop powering the load in response to the second command.

However, when software malfunctions occur in the control unit due to ESD, the control unit may fail to enable the power supply to power the load in response to the first command or may fail to enable the power supply to stop powering the load in response to the second command.

Therefore, there is room for improvement in the art.

### Summary

According to an exemplary embodiment of the invention, a switch circuit controls a power supply, the switch circuit includes a control unit, and a key switch establishes an electrical connection between the power supply and the control unit in response to an operation by a user. When the key switch establishes the electrical connection, the control unit receives a supply voltage from the power supply and is charged-up by the supply voltage to generate a first control signal, the first control signal enables the power supply to power a load.

### BRIEF DESCRIPTION OF THE DRAWINGS

The components of the drawings are not necessarily drawn to scale, the emphasis instead being placed upon clearly illustrating the principles of the embodiments of an electronic device. Moreover, in the drawings, like reference numerals designate corresponding parts throughout two view.

FIG. 1 is a block diagram of an electronic device in accordance with one embodiment.

FIG. 2 is a circuit diagram of the electronic device in FIG. 1 in accordance with one embodiment.

### DETAILED DESCRIPTION

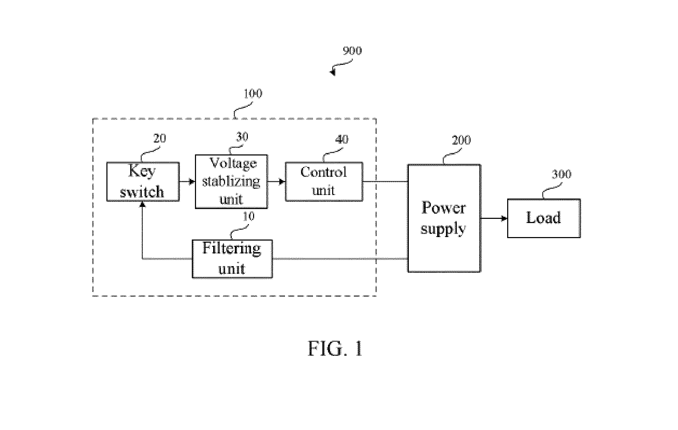

Referring to FIG. 1, an electronic device 900 includes a switch circuit 100, a power supply 200, and a load 300. The switch circuit 100 controls the power supply 200 to power the load 300 or stop powering the load 300.

The switch circuit 100 includes a filtering unit 10, a key switch 20, a voltage stabilizing unit 30, and a control unit 40. The filtering unit 10 filters a supply voltage from the power supply 200. The key switch 20 establishes an electrical connection between the filtering unit 10 and the voltage stabilizing unit 30 or cuts off the electrical connection in response to an operation by the user. In this embodiment, the key switch 20 is a single pole double throw switch.

When the key switch 20 establishes the electrical connection between the filtering unit 10 and the voltage stabilizing unit 30, the voltage stabilizing unit 30 receives the filtered supply voltage from the filtering unit 10, and coverts the filtered supply voltage to a stabilizing voltage. Therefore, the control unit 40 is charged-up by the stabilizing voltage to generate the first control signal. The first control signal enables the power supply 200 to power the load 300.

When the key switch 20 cuts off the electrical connection between the filtering unit 10 and the voltage stabilizing unit 30, the voltage stabilizing unit 30 stops receiving the filtered supply voltage from the filtering unit 10, and stops outputting the stabilizing voltage. Therefore, the control unit 40 is discharged to generate a second control signal, the second control signal enables the power supply 200 to stop powering the load 300. In this embodiment, the power supply 200 provides the supply voltage to the filtering unit 10 and powers the load 300 when the electronic device 900 is powered on. In addition, the power supply 200 provides a supply voltage to the filtering unit 10 and stops powering the load 300 when the electronic device 900 is powered off. In other embodiments, the voltage stabilizing unit 30 is not included in the switch circuit 100, and furthermore, the filtering unit 10 is also not included in the switch circuit 100.

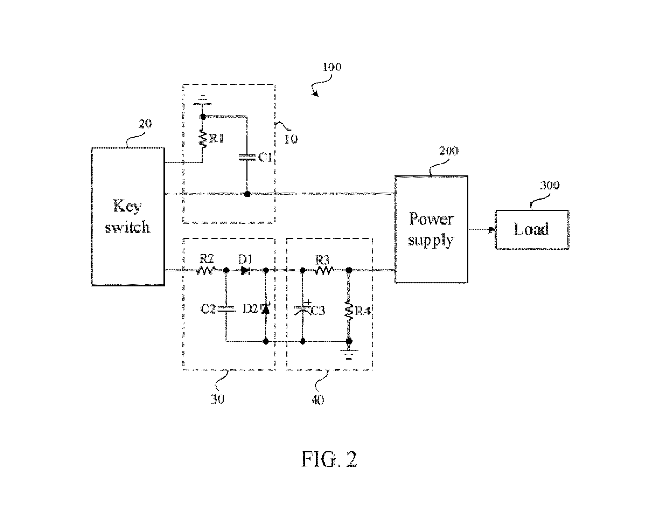

Referring to FIG. 2, the filtering unit 10 includes a filtering capacitor C1 and a resistor R1, one end of the filtering capacitor C1 is connected to the power supply 200 and the key switch 20, the other end of the filtering capacitor C1 is grounded. One end of the resistor R1 is connected to the key switch 20, the other end of the resistor R1 is grounded.

The voltage stabilizing unit 30 includes a zener diode D2, a limiting resistor R2, a capacitor C2, and a diode D1. An anode of the zener diode D2 is grounded, an anode of the diode D1 is connected to the key switch 20 through the limiting resistor R2, a cathode of the diode D1 is connected to a cathode of the zener diode D2. The cathode of the zener diode D2 is connected to the control unit 40. One end of the capacitor C2 is connected to the anode of the diode D1, and the other end of the capacitor C2 is grounded.

The control unit 40 includes a capacitor C3, a first dividing resistor R3, and a second dividing resistor R4. An anode of the capacitor C3 is connected to the cathode of the zener diode D2, a cathode of the capacitor C3 is grounded. One end of the first dividing resistor R3 is connected to the anode of the capacitor C3, and the other end of the first dividing resistor R3 is grounded through the second dividing resistor R4; the other end of the first dividing resistor R3 is further connected to the power supply 200.

In this embodiment, the capacitance of the capacitor C3 is adjustable. In other embodiments, the resistance of the first dividing resistor R3 is adjustable, and the resistance of the second dividing resistor R4 is adjustable. In still other embodiments, the resistance of one of the first dividing resistor R3 and the second dividing resistor R4 is adjustable.

In the electronic device 900, when the key switch 20 establishes the electrical connection between the filtering unit 10 and the voltage stabilizing unit 30 in response to an operation from the user, the capacitor C3 is charged-up by the stabilizing voltage generated by the stabilizing circuit 30 to generate the first control signal, therefore the power supply 200 is enabled by the first control signal to power the load 300.

When the key switch 20 cuts off the electrical connection between the filtering unit 10 and the voltage stabilizing unit 30 in response to an operation by the user, the capacitor C3 is discharged to generate the second control signal, therefore the power supply 200 is enabled by the second control signal to stop powering the load 300. Compared to the prior art, the control signals are generated by hardware and not software, and hence malfunctions in the switch circuit 100 to cause the power supply 200 to be failed to power the load 300 or stop powering the load 300 is minimized or non-existence.

Further alternative embodiments will become apparent to those skilled in the art without departing from the spirit and scope of what is claimed. Accordingly, the present invention should be deemed not to be limited to the above detailed description, but rather only by the claims that follow and equivalents thereof.

## Claims

1. A switch circuit controlling a power supply, the switch circuit comprising:
a control unit; and
a key switch establishing an electrical connection between the power supply and the control unit in response to an operation by a user;
wherein when the key switch establishes the electrical connection, the control unit receives a supply voltage from the power supply and is charged-up by the supply voltage to generate a first control signal, the first control signal enables the power supply to power a load.

2. The switch circuit of claim 1, wherein the key switch further cuts off the electrical connection between the power supply and the control unit in response to user's operation, when the key switch cuts off the electrical connection, the control unit stops receiving the supply voltage and is discharged to generate a second control signal, the second control signal enables the power supply to stop powering the load.

3. The switch circuit of claim 2, further comprising a voltage stabilizing unit connected between the key switch and the control unit, wherein when the key switch establishes the electrical connection, the voltage stabilizing unit receives the supply voltage from the power supply and converts the supply voltage to a stabilizing voltage, and the control unit is charged-up by the stabilizing voltage to generate the first control signal.

4. The switch circuit of claim 3, wherein when the key switch cuts off the electrical connection, the voltage stabilizing unit stops receiving the supply voltage and stops outputting the stabilizing voltage to the control unit, and the control unit is discharged to generate the second control signal.

5. The switch circuit of claim 2, 3 or 4, wherein the control unit comprises a capacitor, a first dividing resistor, and a second dividing resistor; an anode of the capacitor is connected to the key switch, a cathode of the capacitor is grounded; one end of the first dividing resistor is connected to the anode of the capacitor, the other end of the first dividing resistor is grounded through the second dividing resistor; the other end of the first dividing resistor is further connected to the power supply.

6. The switch circuit of claim 5, wherein the capacitance of the capacitor is adjustable.

7. The switch circuit of claim 5 or 6, wherein the resistance of the first dividing resistor is adjustable, and the resistance of the second dividing resistor is adjustable.

8. The switch circuit of claim 5, 6 or 7, wherein the resistance of one of the first dividing resistor and the second dividing resistor is adjustable.

9. The switch circuit of claim 3, wherein the voltage stabilizing unit comprises a zener diode, an anode of the zener diode is grounded, a cathode of the zener diode is connected between the key switch and the control unit.

10. The switch circuit of claim 9, wherein the voltage stabilizing unit further comprises a limiting resistor and a diode, an anode of the diode is connected to the key switch through the limiting resistor, a cathode of the diode is connected to the cathode of the zener diode.

11. The switch circuit of claim 10, wherein the voltage stabilizing unit further comprises a capacitor, one end of the capacitor is connected to the anode of the diode, and the other end of the capacitor is grounded.

12. An electronic device, comprising:
a power supply;
a load; and
a switch circuit controlling the power supply, the switch circuit comprising:
a control unit; and
a key switch establishing an electrical connection between the power supply and the control unit in response to an operation by a user;
wherein when the key switch establishes the electrical connection, the control unit receives a supply voltage from the power supply and is charged-up by the supply voltage to generate a first control signal, the first control signal enables the power supply to power the load.

13. The electronic device of claim 12, wherein the key switch further cuts off the electrical connection between the power supply and the control unit in response to user's operation, when the key switch cuts off the electrical connection, the control unit stops receiving the supply voltage and is discharged to generate a second control signal, the second control signal enables the power supply to stop powering the load.

14. The electronic device of claim 13, wherein the switch circuit further comprises a voltage stabilizing unit connected between the key switch and the control unit, wherein when the key switch establishes the electrical connection, the voltage stabilizing unit receives a supply voltage from the power supply and converts the supply voltage to a stabilizing voltage, and the control unit is charged-up by the stabilizing voltage to generate the first control signal.

15. An electronic device, comprising:
a power supply;
a load; and
a switch circuit controlling the power supply, the switch circuit comprising:
a control unit; and
a key switch establishing an electrical connection between the power supply and the control unit in response to an operation by a user;
wherein the power supply provides a supply voltage to the key switch and stops powering the load when the electronic device is powered off;
when the key switch establishes the electrical connection, the control unit receives a supply voltage from the power supply and is charged-up by the supply voltage to generate a first control signal, the first control signal enables the power supply to power the load.
